# EUROPÄISCHE PATENTSCHRIFT

(11) **EP 1 936 004 B1**
(45) Veröffentlichungstag und Bekanntmachung des Hinweises auf die Patenterteilung: **01.02.2012**
(21) Anmeldenummer: 07020677.6
(22) Anmeldetag: 23.10.2007
(51) Int. Cl.: C23C 14/08

(54) **Transparente Barrierefolien für die Verpackungsindustrie**
Transparent barrier films for the packaging industry
Films barrières transparents pour l'industrie de l'emballage

(30) Priorität: 23.12.2006 DE 102006062112; 19.01.2007 DE 102007003766
(43) Veröffentlichungstag der Anmeldung: 25.06.2008
(73) Patentinhaber: HVB Hoch-Vakuum-Beschichtungs GmbH High vacuum coating, 12623 Berlin (DE)
(72) Erfinder: Rieker, Frank, 59510 Lippetal-Brockhausen (DE); Grottke, Katrin, 10407 Berlin (DE)
(74) Vertreter: Gesthuysen, von Rohr & Eggert

(56) Entgegenhaltungen:
- EP-A- 0 695 815
- WO-A-2004/050945
- DE-C1- 4 343 040
- DE-C1- 19 612 345
- DE-C1- 19 845 268
- JP-A- 11 170 427
- SCHILLER N ET AL: "Deposition of alumina layers on plastic films using conventional boat evaporators" ANNUAL TECHNICAL CONFERENCE PROCEEDINGS SOCIETY OF VACUUM COATERS, ALBUQUERQUE, NM, US, Nr. 39, 1996, Seiten 404-412, XP009094348

## Beschreibung

Die vorliegende Erfindung betrifft transparente Barrierefolien, welche sich insbesondere für die Verpackungsindustrie, vorzugsweise zur Verpackung von Lebensmitteln, eignen und ein Verfahren zur Herstellung derartiger Barrierefolien sowie die Verwendung dieser Barrierefolien, insbesondere im Bereich der Verpackungsindustrie, vorzugsweise zum Verpacken von Lebensmitteln.

In der Verpackungsindustrie, insbesondere zur Verpackung von Lebensmitteln, werden eine Reihe von Materialien, insbesondere Kunststoffmaterialien, eingesetzt, welche die verpackten Lebensmittel vor einem vorzeitigen Verderb und einer Kontamination mit Keimen bewahren müssen. Zu diesem Zweck kommen vielfach film- bzw. folienartige Verpackungsmaterialien mit Sperrschicht- bzw. Barriereschichteigenschaften zum Einsatz, welche insbesondere eine gute Sperr- bzw. Barrierewirkung gegenüber Sauerstoff und Wasserdampf, gegebenenfalls auch gegenüber Aromastoffen, aufweisen.

Die Beschichtung bandförmiger bzw. film- und folienförmiger Substrate mit einer Sperr- oder Barriereschicht ist ein wichtiger Verfahrensschritt bei der Herstellung von verschiedenen Verpackungsmaterialien. Beispielsweise können verschiedene Polymermaterialien nach Aufdampfen von dünnen Metallschichten, beispielsweise auf Basis von Aluminium, zu Verpackungsmaterialien weiterverarbeitet werden, welche eine gute Sperrwirkung gegenüber Sauerstoff und Wasserdampf, gegebenenfalls auch gegenüber Aromastoffen, aufweisen. Verpackungen, die mit einer dünnen Metallschicht versehen sind, sind jedoch nicht transparent und haben eine hohe Mikrowellenabsorption. Dies ist für manche Anwendungen, insbesondere im Bereich von Lebensmittelverpackungen, nicht erwünscht.

Deshalb werden im Stand der Technik metallische Sperr- bzw. Barriereschichten durch verschiedene Sperr- bzw. Barriereschichten auf Basis von Metalloxiden, insbesondere auf Basis von Oxiden des Siliziums, Aluminiums und Magnesiums, ersetzt.

Die reaktive Verdampfung von Aluminium aus sogenannten Verdampferschiffchen stellt dabei eine Möglichkeit dar, den Vorteil einer niedrigen Verdampfungstemperatur mit einer gewissen optischen Transparenz und einer Mikrowellendurchlässigkeit des Verpackungsendmaterials zu kombinieren (vgl. z. B. DE 196 12 345 C1, DE 198 45 268 C1 und DE 102 55 822 A1). Daneben kommen jedoch auch Verfahren mit Elektronenstrahl- und Induktionsverdampfern in Frage.

Für Barriereschichten dieser Art gilt, daß die optische Transmission von dem Mischungsverhältnis von Metall (z. B. Silizium, Aluminium oder Magnesium) und seinem Oxid - im folgenden auch als Stöchiometrie bezeichnet - abhängt - abgesehen natürlich von der Dicke der Barriereschicht. In allgemeinen nimmt mit steigendem Oxidanteil die optische Transmission zu, während sich damit jedoch die Barrierewirkung der Schicht verringert. Diesbezüglich existiert ein Arbeitsbereich im geringfügig unterstöchiometrischen Bereich, dessen untere Grenze durch die höchstznlässige Absorption und dessen obere Grenze durch die geforderten Mindestwerte der Barriere bestimmt wird (vgl. hierzu N. Schiller et al., Surf. Coat, Technol., 86/87 (1996) 776-782). Es ist daher üblich, die Einhaltung dieses Arbeitsbereiches durch Bereitstellung der Reaktionspartner (d. h. Metall, insbesondere Aluminium, Magnesium oder Silizim, einerseits und Sauerstoff andererseits) in einem bestimmten einstellbaren Mengenverhältnis zu gewährleisten (vgl. JP 62-103 359 A).

Insbesondere auf dem Gebiet von Massenverpackungen, insbesondere im Lebensmittelbereich, spielt die visuelle Beurteilung des verpackten Produkts eine große Rolle, so daß bereits geringe Schwankungen der optischen Transmission bzw. Transparenz in bezug auf beschichtete Barrierefolien nicht akzeptabel sind. Daher wurden bereits zahlreiche Versuche unternommen, eine gleichmäßig gute Transmission über große Beschichtungsflächen zu erzielen.

Bislang ist es aber nicht gelungen, transparente Barrierefolien der vorgenannten Art zu fertigen, die eine hohe optische Transmission bzw. Transparenz gleichmäßig über die gesamte Folie mit guten Barriereeigenschaften der Folie, insbesondere in bezug auf Sauerstoff und Wasserdampf, gegebenenfalls auch gegenüber Aromastoffen, miteinander vereinen.

So betrifft die wissenschaftliche Publikation gemäß Schiller et al.: "Deposition of Alumina Layers of Plastic Films Using Conventional Boat Evaporators", Annual Technical Conference Proceedings Society of Vacuum Coaters, Albuquerque, NM, US, Nr. 39, 1996, Seiten 404 bis 412, XP009094348 experimentelle Untersuchungen zur Beschichtung von Folien mit Aluminiumoxiden unter Verwendung eines Schiffchenverdampfers ("*boat evaporator*"), wobei insbesondere darauf abgestellt wird, durch eine optimierte Kontrolle der Verfahrensparameter verbesserte Eigenschaften hinsichtlich der Barriereeigenschaften und der optischen Transparenz der resultierenden Folien zu erhalten.

Weiterhin betrifft die EP 0 695 815 A1 ein Verfahren zum Aufbringen einer transparenten Metalloxidschicht auf eine Folie, wobei in einem Rezipienten ein Metall verdampft und in der Dampfphase mit Sauerstoff in Berührung gebracht wird. Dabei wird in dem Rezipienten eine zu keiner ausreichenden Transparenz der Metalloxidschicht führende, leicht unterstöchiometrische Sauerstoffmenge eingestellt. Zur Ermittlung der aufgebrachten Schichtdicke und zur Steuerung der Abdampfraten werden optische Sensoren eingesetzt. Nach Ermittlung der Transparenz durch die Sensoren wird eine Nachoxidation der Schicht vorgenommen.

Die DE 43 43 041 C1 betrifft eine Barrierefolie, welche aus einem anorganischen Schichtsystem auf einer flexiblen Unterlage besteht, wobei auf einem flexiblen Basismaterial zunächst eine gesputterte Unterschicht, darauf eine plasmagestützt aufgedampfte Barriereschicht und hierauf eine gesputterte Deckschicht aufgebracht sind und wobei Unterschicht, Barriereschicht und Deckschicht kontinuierlich ineinander übergehen. Die Halbwertsdicke von Unterschicht und Deckschicht soll klein gegen die Halbwertsdicke der Barriereschicht sein, wobei die Halbwertsdicke von Unterschicht und Deckschicht jeweils 0,2 bis 2 nm und die Halbwertsdicke der Barriereschicht 10 bis 100 nm betragen soll. Alle drei Schichten sollen als Gradientenschichten ausgebildet sein, und das Material von Unterschicht und Deckschicht soll mit einem Konzentrationsgefälle als Dotierungsmaterial in der Barriereschicht enthalten sein.

Das der vorliegenden Erfindung zugrundeliegende Problem liegt folglich in der Bereitstellung einer transparenten Sperrschicht- bzw. Barrierefolie, insbesondere mit Sperr- bzw. Barriereeigenschaften gegenüber Sauerstoff und Wasserdampf, gegebenenfalls aber auch gegenüber Aromastoffen, welche die zuvor geschilderten Nachteile des Standes der Technik zumindest weitgehend vermeidet oder aber wenigstens abschwächt, sowie in der Bereitstellung eines entsprechenden Herstellungsverfahrens für eine solche Folie. Insbesondere sollte eine solche Folie eine gute optische Transmission bzw. Transparenz im Bereich des sichtbaren Lichts bei hoher Gleichmäßigkeit über die gesamte Folie mit guten Barriereeigenschaften der vorgenannten Art in einem einzigen Material vereinigen.

Zur Lösung des zuvor geschilderten Problems schlägt die vorliegende Erfindung somit - gemäß einem ersten Aspekt der vorliegenden Erfindung - eine transparente Barriere- bzw. Sperrschichtfolie (d. h. einem transparenten Barriere- bzw. Sperrschichtfilm) nach Anspruch 1 vor. Weitere, insbesondere vorteilhafte Ausgestaltungen der erfindungsgemäßen Barrierefolie sind Gegenstand der diesbezüglichen Unteransprüche.

Weiterer Gegenstand der vorliegenden Erfindung ist - gemäß einem zweiten Aspekt der vorliegenden Erfindung - ein Verfahren zur Herstellung der erfindungsgemäßen Barrierefolien gemäß Anspruch 18.

Schließlich ist weiterer Gegenstand der vorliegenden Erfindung - gemäß einem dritten Aspekt der vorliegenden Erfindung - die Verwendung der erfindungsgemäßen Barrierefolien, insbesondere in der Verpackungsindustrie bzw. zur Verpackung vorzugsweise von Lebensmitteln, wie in Anspruch 19 definiert.

Gegenstand der vorliegenden Erfindung - gemäß einem **ersten** Aspekt der vorliegenden Erfindung - ist somit eine transparente Barrierefolie, welche sich insbesondere zur Verpackung von Lebensmitteln eignet, wobei die Barrierefolie eine Substratfolie (d. h. also eine Trägerfolie) aufweist, welche auf mindestens einer ihrer beiden Seiten mit einer Barriereschicht auf Basis von Aluminiumoxid (A10x) versehen ist,
- wobei die Substratfolie auf Basis mindestens eines thermoplastischen Polymers ausgebildet ist, welches aus der Gruppe von Polyethylenterephthalat (PET); Polyolefinen, vorzugsweise Polypropylenen (z. B. OPP bzw. orientiertes Polypropylen); Polylactiden (Polymilchsäuren, PLA) sowie deren Mischungen und Kombinationen ausgewählt ist,
- wobei die Barrierefolie Sperrschichteigenschaften gegenüber Wasserdampf und Sauerstoff aufweist, wobei die Barrierefolie eine Wasserdampfdurchlässigkeit im Bereich von 1/5 bis 1/500 der Wasserdampfdurchlässigkeit der unbeschichteten Substratfolie und eine Sauerstoffdurchlässigkeit im Bereich von 1/5 bis 1/500 der Sauerstoffdurchlässigkeit der unbeschichteten Substratfolie aufweist,
- wobei die Barrierefolie eine optische Transmission (Transparenz) bei einer Wellenlänge im Bereich von 400 bis 600 nm, insbesondere bei etwa 500 nm, von mindestens 96 % aufweist und
- wobei die aluminiumoxidbasierte Barriereschicht abriebfest mit der unterliegenden Substratfolie verbunden ist, wobei die Schälkraft der aluminiumoxidbasierten Barriereschicht zu der unterliegenden Substratfolie mindestens 0,4 N/15 mm beträgt.

Im Rahmen der vorliegenden Erfindung werden die Begriffe "Film" einerseits und "Folie" andererseits synonym verwendet. Gleichermaßen werden die Begriffe bzw. Wortbestandteile "Barriere"/"Barriere..." einerseits und "Sperrschicht"/"Sperrschicht..." andererseits synonym verwendet.

Der Begriff der Transmission bzw. Transparenz, wie er erfindungsgemäß verwendet wird, bezeichnet insbesondere die Durchlässigkeit der erfindungsgemäßen Barrierefolie für das Meßlicht, d. h. bei den vorgenannten Wellenlängenbereichen bzw. Wellenlängen, ausgedrückt als (Rein-)Transmissionsgrad T = φₑₓ/φᵢₙ, wobei φₑₓ den Strahlungsfluß des austretenden bzw. durchgelassenen Lichtstrahls und φᵢₙ den Strahlungsfluß des einfallenden Lichtstrahls bezeichnet. Früher wurde für den vorgenannten Quotienten T = φₑₓ/φᵢₙ die Bezeichnung "I/I₀" (abgeleitet von der Intensität) verwendet. Im Rahmen der vorliegenden Erfindung werden die Begriffe "Transmission" und "Transparenz" synonym verwendet. Die Begriffe "optische Transmission" oder synonym "optische Transparenz" werden im Rahmen der vorliegenden Erfindung verwendet, um speziell die Transmission bzw. Transparenz im Bereich des sichtbaren Lichts, insbesondere bei den vorgenannten Wellenlängen, zu bezeichnen.

Für weitergehende diesbezügliche Einzelheiten zum Begriff der "Transmission" bzw. der "Transparenz" kann beispielsweise verwiesen werden auf Römpp Chemielexikon, 10. Auflage, Band 6, 1999, Georg Thieme Verlag Stuttgart/New York, Seite 4612, Stichwort; "Transmission", sowie die dort angegebenen Querverweise und die dort referierte Literatur, wobei die vorgenannten Literaturstellen hiermit durch Bezugnahme vollinhaltlich eingeschlossen sind.

Im Rahmen der vorliegenden Erfindung beziehen sich alle vorgenannten und noch nachstehend genannten Transmissions- bzw. Transparenzangaben auf die Bestimmungsmethode gemäß ASTM D1746-03 *("Standard Test Method for Transparency of Plastic Sheeting")* bei den jeweils angegebenen Meßwellenlängen bzw. Meßwellenlängenbereichen.

Wie zuvor beschrieben, weisen die erfindungsgemäßen Barrierefolien eine exzellente optische Transmission bzw. Transparenz auf, und dies gleichmäßig über die gesamte Barrierefolie (z. B. auch in den Randbereichen der Folie).

Wie zuvor geschildert, weist die erfindungsgemäße Barrierefolie bei einer Wellenlänge im Bereich von 400 bis 600 nm, insbesondere bei etwa 500 nm, eine optische Transmission bzw. eine optische Transparenz gemäß ASTM D1746-03 von mindestens 96 % auf. Der Begriff "etwa 500 nm" bezeichnet eine Meßwellenlänge von im allgemeinen (500 ± 25) nm.

Erfindungsgemäß ist es bevorzugt, wenn die Barrierefolie nach der vorliegenden Erfindung sogar noch höhere bzw. noch bessere Transmissions-/Transparenzwerte als den vorgenannten Mindestwert von 96 % aufweist. Vorteilhafterweise weist die Barrierefolie nach der vorliegenden Erfindung eine optische Transmission (Transparenz), bestimmt nach ASTM D1746-03 bei einer Wellenlänge von 400 bis 600 nm, insbesondere bei etwa 500 nm, von mindestens 97 %, vorzugsweise mindestens 98 %, besonders bevorzugt mindestens 99 %, auf.

Die erfindungsgemäße Barrierefolie ist somit hochtransparent und ermöglicht auf diese Weise bei ihrer Verwendung als Verpackungsmaterial, insbesondere von Lebensmitteln, eine gute visuelle Kontroll- bzw. Überprüfungsmöglichkeit der hiermit verpackten Lebensmittel. Gleichzeitig wird das hiermit verpackte Lebensmittel aber in ausreichender Weise gegenüber äußeren Einflüssen, insbesondere Sauerstoff und Wasserdampf, geschützt, da die erfindungsgemäße Barrierefolie darüber hinaus über ausgezeichnete Sperrschichteigenschaften verfügt.

Wie zuvor geschildert, besteht die erfindungsgemäße Barrierefolie aus einem film- bzw. folienartigen Substrat ("Substratfolie") und einer hierauf aufgetragenen Barriereschicht, wobei letztere der erfindungsgemäßen Barrierefolie besondere Sperrschichteigenschaften gegenüber Sauerstoff und Wasserdampf sowie gegebenenfalls verschiedenen Aromen verleiht. Die konkreten Zahlenwerte für diese Barriereeigenschaften hängen entscheidend vom Polymer der Substratfolie ab und sind für die verschiedenen Substratpolymere im einzelnen angegeben.

Erfindungsgemäß weist die Barrierefolie infolge der auf die Substratfolie aufgetragenen aluminiumoxidbasierten Barriereschicht eine Wasserdampfdurchlässigkeit - synonym auch als Wasserdampfpermeation bezeichnet - auf, welche einem Wert im Bereich von 1/5 bis 1/500, insbesondere 1/10 bis 1/200, vorzugsweise 1/10 bis 1/100, der Wasserdampfdurchlässigkeit der unbeschichteten Substratfolie entspricht. Mit anderen Worten ist die Wasserdampfdurchlässigkeit der Substratfolie infolge der auf die Substratfolie aufgetragenen aluminiumoxidbasierten Barriereschicht um 1/5 bis 1/500, insbesondere 1/10 bis 1/200, vorzugsweise 1/10 bis 1/100, erniedrigt, bezogen auf die reine (d. h. unbeschichtete bzw. barriereschichtfreie) Substratfolie. Angaben der Wasserdampfdurchlässigkeit beziehen sich im Rahmen der vorliegenden Erfindung auf DIN 53122/II; sofern nichts Abweichendes angegeben ist, beziehen sich nachfolgend angegebene Zahlenwerte für die Wasserdampfdurchlässigkeit auf die Einheit "g/m²· 24 h", im allgemeinen bei 1 bar Druck (Wasserdampfpartialdruck), und werden, sofern nichts Gegenteiliges angegeben ist, bei 23 °C und bei 50 %, 85 % oder 90 % relativer Luftfeuchtigkeit (r. F.) bestimmt.

Entsprechendes gilt auch für die Sauerstoffdurchlässigkeit der erfindungsgemäßen Barrierefolie: Erfindungsgemäß weist die Barrierefolie infolge der auf die Substratfolie aufgetragenen aluminiumoxidbasierten Barriezeschicht eine Sauerstoffdurchlässigkeit - synonym auch als Sauerstoffpermeation bezeichnet - auf, welche einem Wert im Bereich von 1/5 bis 1/500, insbesondere 1/10 bis 1/200, vorzugsweise 1/10 bis 1/100, der Sauerstoffdurchlässigkeit der unbeschichteten Substratfolie entspricht. Mit anderen Worten ist die Sauerstoffdurchlässigkeit der Substratfolie infolge der auf die Substratfolie aufgetragenen aluminiumoxidbasierten Barriereschicht um 1/5 bis 1/500, insbesondere 1/10 bis 1/200, vorzugsweise 1/10 bis 1/100, erniedrigt, bezogen auf die reine (d. h. unbeschichtete bzw. barriereschichtfreie) Substratfolie. Angaben der Sauerstoffdurchlässigkeit beziehen sich im Rahmen der vorliegenden Erfindung auf DIN 53380/II; sofern nichts Abweichendes angegeben ist, beziehen sich nachfolgend angegebene Zahlenwerte für die Sauerstoffdurchlässigkeit auf die Einheit "cm³/m²·24 h", im allgemeinen bei 1 bar Druck (Sauerstoffpartialdruck), und werden, sofern nichts Gegenteiliges angegeben ist, bei 23 °C und bei 50 % relativer Luftfeuchtigkeit (r. F.) bestimmt.

Um eine gute optische Transmission bzw. Transparenz im Bereich des sichtbaren Lichtes, insbesondere im Bereich der vorgenannten Meßwellenlänge, d. h. 400 bis 600 nm, insbesondere bei etwa 500 nm, zu gewährleisten, ist die aluminiumoxidbasierte Barriereschicht nur mit extrem dünnen Schichtdicken auf die Substratfolie aufgetragen. Im allgemeinen variiert die Dicke der aluminiumoxidbasierten Barriereschicht im Bereich von 1 bis 100 nm, insbesondere 2 bis 25 nm, vorzugsweise 3 bis 50 nm, besonders bevorzugt 5 bis 40 nm. Dennoch kann es - einzelfallbedingt oder anwendungsbezogen - erforderlich sein, von den vorgenannten Werten abzuweichen, ohne daß der Fachmann den Rahmen der vorliegenden Erfindung verläßt.

Derartig dünne Schichtdicken für die aluminiumoxidbasierte Barriereschicht lassen sich dadurch realisieren, daß die Substratfolie mit der aluminiumoxidbasierten Barriereschicht bedampft wird, insbesondere mittels Vakuumbeschichtungstechniken, vorzugsweise Vakuumplasmabeschichtungstechniken, wie dies nachfolgend noch beschrieben ist, Derartige Techniken sind dem Fachmann als solche bekannt; im Rahmen der vorliegenden Erfindung wird jedoch erstmals eine Barrierefolie bereitgestellt, die für speziell ausgewählte Substratmaterialien exzellente optische Eigenschaften mit hervorragenden Sperrschichteigenschaften miteinander vereint.

Gewichtsbezogen macht die aluminiumoxidbasierte Barriereschicht im allgemeinen weniger als 5 Gew.-%, insbesondere weniger als 4 Gew.-%, vorzugsweise weniger als 3 Gew.-%, besonders bevorzugt weniger als 2 Gew.-%, ganz besonders bevorzugt weniger als 1 Gew.-%, bezogen auf das Gesamtgewicht der Barrierefolie, aus. Dennoch kann es, insbesondere einzelfallbedingt oder aber anwendungsbezogen, erforderlich werden, von den vorgenannten Werten abzuweichen, ohne daß der Fachmann den Rahmen der vorliegenden Erfindung verläßt.

Infolge der nur sehr geringen Mengen an Aluminiumoxid für die Ausbildung der extrem dünnen Barriereschicht lassen sich die erfindungsgemäßen Barrierefolien nach ihrer bestimmungsgemäßen Verwendung ohne weiteres entsorgen oder aber auch rezyklieren, insbesondere bei Verwendung von sogenannten Biokunststoffen ("PLA") für die Ausbildung der Substratfolie.

Im allgemeinen bildet die aluminiumoxidbasierte Barriereschicht ein zumindest im wesentlichen gleichmäßige, insbesondere gleichmäßig dicke und/oder gleichmäßig dichte, kontinuierliche und geschlossene Schicht auf der Substratfolie aus.

Erfindungsgemäß ist die aluminiumoxidbasierte Barriereschicht abriebfest mit der unterliegenden Substratfolie verbunden. Erfindungsgemäß beträgt dabei die Schälkraft der aluminiumoxidbasierten Barriereschicht zu der unterliegenden Substratfolie, insbesondere im feuchten Zustand, mindestens 0,4 N/15 mm und liegt insbesondere im Bereich von 0,4 bis 20 N/15 mm, vorzugsweise 0,6 bis 16 N/15 mm, besonders bevorzugt 1 bis 10 N/15 mm; die vorgenannten Zahlenbereiche beziehen sich die Schälkraft bei 180° an allseitig 15 mm breiten Probestücken des Films bei einer Schälrate von 300 mm/min (vgl. hierzu auch EP 1298 229 A1 bezüglich der Bestirnmungsmethode).

Die Abriebfestigkeit des Verbunds der aluminiumoxidbasierten Barriereschicht auf der Substratfolie kann noch dadurch gesteigert werden, daß die aluminiumoxidbasierte Barriereschicht auf ihrer von der Substratfolie abgewandten Seite mit einer Schutz- oder Versiegelungsschicht, insbesondere in Form eines Lacks, eines Primers (Haftvermittlers) oder einer Folie, versehen ist. Als Schutz- oder Versiegelungsschicht kann beispielsweise eine Kunststoffolie (z. B. Polyethylenfolie) dienen, welche beispielsweise mittels eines Kaschierklebers auf die Barriereschicht laminiert sein kann. Alternativ eignen sich auch Lacke (z. B. kunststoffbasierte Lacke) oder aber auch sogenannte Primer oder Haftvermittler.

Im Unterschied zur aluminiumoxidbasierten Barriereschicht ist die auf einem thermoplastischen Polymer basierende Substratfolie deutlich dicker ausgebildet. Im allgemeinen weist die thermoplastische Substratfolie eine Dicke im Bereich von 1 bis 100 µm, insbesondere 2,5 bis 75 µm, vorzugsweise 5 bis 50 µm, besonders bevorzugt 6 bis 25 µm, ganz besonders bevorzugt 7 bis 22 µm, auf. Die Dicke variiert insbesondere in Abhängigkeit von den Substratmaterialien bzw. Substratpolymeren.

Als Substratfolie kann beispielsweise eine PET-Folie verwendet werden. Erfindungsgemäß als Substratfolie geeignete PET-Folien besitzen vorteilhafterweise eine Zugfestigkeit in mindestens Quer- oder Längsrichtung, vorzugsweise in Quer- und Längsrichtung, bestimmt nach DIN 53455 bei 23 °C und bei 50 % relativer Luftfeuchtigkeit, von wenigstens 100 N/mm², insbesondere wenigstens 150 N/mm², bevorzugt wenigstens 200 N/mm², ganz besonders bevorzugt wenigstens 220 N/mm². Erfindungsgemäß als Substratfolien geeignete PET-Folien können eine Reißdehnung in mindestens Quer- oder Längsrichtung, vorzugsweise in Quer- und Längsrichtung, bestimmt nach DIN 53455 bei 23 °C und bei 50 % relativer Luftfeuchtigkeit, von wenigstens 80 %, insbesondere wenigstens 85 %, bevorzugt wenigstens 90 %, ganz besonders bevorzugt wenigstens 100 %, aufweisen. Erfindungsgemäß als Substratfolie geeignete PET-Folien können eine Dichte, bestimmt nach ASTM D1505-68, Methode C, bei 23 °C von 1,2 bis 1,4 g/cm³*,* insbesondere etwa 1,3 g/cm³, ganz besonders bevorzugt etwa 1,395 g/cm³, aufweisen. Die als Substratfolie eingesetzten PET-Folien können einen Young-Modul in mindestens Quer- oder Längsrichtung, vorzugsweise in Quer- und Längsrichtung, bestimmt nach ISO 527-1-2 bei 23 °C und bei 50 % relativer Luftfeuchtigkeit, von wenigstens 4.000 N/mm², insbesondere wenigstens 4.200 N/mm², bevorzugt wenigstens 4.400 N/mm², ganz besonders bevorzugt wenigstens 5.000 N/mm², aufweisen. Die als Substratfolie eingesetzten PET-Folien können dabei Dicken im Bereich von 1 bis 100 µm, insbesondere 2,5 bis 75 µm, vorzugsweise 5 bis 50 µm, besonders bevorzugt 6 bis 25 µm, ganz besonders bevorzugt 7 bis 22 µm, aufweisen. Gemäß einer besonderen Ausführungsform kann die Substratfolie als eine einschichtige PET-Folie ausgebildet sein. Gemäß wiederum einer anderen Ausführungsform kann die Substratfolie als eine mehrschichtige PET-Folie ausgebildet sein; beispielsweise kann die mehrschichtige PET-Folie mindestens drei PET-Lagen, vorzugsweise drei bis sieben PET-Lagen, umfassen, welche miteinander verbunden, insbesondere laminiert oder coextrudiert, sein können; die unterschiedlichen PET-Lagen können zumindest teilweise aus unterschiedlichen PET-Typen und/oder unterschiedlichen PET-Zusammensetzungen und/oder PET-Qualitäten gebildet sein, wodurch es gelingt, PET-Zusammensetzungen unterschiedlicher Art miteinander zu kombinieren und auf diese Weise unterschiedliche Eigenschaften unterschiedlicher Materialien zu erhalten bzw. zu kombinieren oder aber auch kostengünstigere Materialien (z. B. in den Kernschichten, so z. B. Recyclingmaterialien) einzusetzen.

Bei der vorgenannten Ausführungsform, wonach als Substratfolie eine PET-Folie, insbesondere wie zuvor beschrieben, verwendet wird, resultiert eine erfindungsgemäße Barrierefolie, welche insgesamt (d. h. bezogen auf die Barrierefolie als solche)
- eine Wasserdampfdurchlässigkeit, bestimmt nach DIN 53122/II bei 23 °C und bei 85 % relativer Luftfeuchtigkeit, von weniger als 10 g/m²· 24 h, insbesondere weniger als 5 g/m²·24 h, vorzugsweise weniger als 4 g/m²· 24 h, bevorzugt weniger als 3 g/m²· 24 h, besonders bevorzugt weniger als 2 g/m²· 24 h, und/oder
- eine Sauerstoffdurchlässigkeit, bestimmt nach DIN 53380/II bei 23 °C und bei 50 % relativer Luftfeuchtigkeit, von weniger als 10 cm³/m²· 24 h, insbesondere weniger als 5 cm³/m²· 24 h, vorzugsweise weniger als 4 cm³/m² . 24 h, bevorzugt weniger als 3 cm³/m² . 24 h,
aufweist.

Gemäß einer alternativen Ausführungsform kann als Substratfolie beispielsweise eine Polyolefinfolie, insbesondere eine Polypropylenfolie, vorzugsweise eine gereckte Polypropylenfolie (OPP-Folie), besonders bevorzugt eine biaxial gereckte Polypropylenfolie (BOPP-Folie), verwendet werden. Erfindungsgemäß als Substratfolie geeignete Polyolefinfolien besitzen vorteilhafterweise eine Zugfestigkeit in mindestens Quer- oder Längsrichtung, vorzugsweise in Quer- und Längsrichtung, bestimmt nach DIN 53455 bei 23 °C und bei 50 % relativer Luftfeuchtigkeit, von wenigstens 100 N/mm², insbesondere wenigstens 150 N/mm², bevorzugt wenigstens 200 N/mm², ganz besonders bevorzugt wenigstens 300 N/mm². Erfindungsgemäß als Substratfolien geeignete Polyolefinfolien können eine Reißdehnung in mindestens Quer- oder Längsrichtung, vorzugsweise in Quer- und Längsrichtung, bestimmt nach DIN 53455 bei 23 °C und bei 50 % relativer Luftfeuchtigkeit, von wenigstens 60 %, insbesondere wenigstens 100 %, bevorzugt wenigstens 125 %, ganz besonders bevorzugt wenigstens 150 %, aufweisen. Weiterhin können Erfindungsgemäß als Substratfolien geeignete Polyolefinfolien eine Dichte, bestimmt nach ASTM D1505-68, Methode C, bei 23 °C von 0,85 bis 0,95 g/cm³, insbesondere etwa 0,9 g/cm³, ganz besonders bevorzugt etwa 0,91 g/cm³, aufweisen. Weiterhin können erfindungsgemäß als Substratfolien geeignete Polyolefinfolien eine Dicke im Bereich von 1 bis 100 µm, insbesondere 2,5 bis 75 µm, vorzugsweise 5 bis 50 µm, besonders bevorzugt 10 bis 30 µm, ganz besonders bevorzugt 12 bis 25 µm, aufweisen. Gemäß einer besonderen Ausführungsform kann die Substratfolie als eine einschichtige Polyolefinfolie ausgebildet sein. Gemäß wiederum einer anderen Ausführungsform kann die Substratfolie als eine mehrschichtige Polyolefinfolie ausgebildet sein, wobei die mehrschichtige Polyolefinfolie mindestens drei Polyolefinlagen, vorzugsweise drei bis sieben Polyolefinlagen, umfassen, welche miteinander verbunden, insbesondere laminiert oder coextrudiert, sein; dabei können die unterschiedlichen Polyolefinlagen zumindest teilweise aus unterschiedlichen Polyolefintypen und/oder unterschiedlichen Polyolefinzusammensetzungen und/oder unterschiedlichen Polyolefinqualitäten gebildet sein, wodurch es gelingt, Polyolefinzusammensetzungen unterschiedlicher Art miteinander zu kombinieren und auf diese Weise unterschiedliche Eigenschaften unterschiedlicher Materialien zu erhalten bzw. zu kombinieren oder aber auch kostengünstigere Materialien (z. B. in den Kernschichten, so z. B. Recyclingmaterialien) einzusetzen.

Bei der vorgenannten Ausführungsform, wonach als Substratfolie eine Polyolefinfolie, insbesondere wie zuvor beschrieben, verwendet wird, resultiert eine erfindungsgemäße Barrierefolie, welche insgesamt (d. h. bezogen auf die Barrierefolie als solche)
- eine Wasserdampfdurchlässigkeit, bestimmt nach DIN 53122/II bei 23 °C und bei 85 % relativer Luftfeuchtigkeit, von weniger als 10 g/m². 24 h, insbesondere weniger als 5 g/m²· 24 h, vorzugsweise weniger als 3 g/m²·24 h, bevorzugt weniger als 2 g/m²·24 h, besonders bevorzugt weniger als 1 g/m²·24 h, und/oder
- eine Sauerstoffdurchlässigkeit, bestimmt nach DIN 53380/II bei 23 °C und bei 50 % relativer Luftfeuchtigkeit, von weniger als 100 cm³/m²· 24 h, insbesondere weniger als 90 cm³/m²· 24 h, vorzugsweise weniger als 80 cm³/m² . 24 h, bevorzugt weniger als 70 cm³/m²· 24 h, besonders bevorzugt weniger als 60 cm³/m²· 24 h, ganz besonders bevorzugt weniger als 50 cm³/m²· 24 h,
aufweist.

Gemäß einer alternativen Ausführungsform kann als Substratfolie beispielsweise eine polylactidbasierte (PLA-basierte, polymilchsäurebasierte) Folie, wie eingangs beschrieben, verwendet werden.

Erfindungsgemäß bevorzugt ist es, wenn die Barrierefolie sterilisierfest ist, insbesondere bei Temperaturen im Bereich von 100 bis 130 °C bei einer Dauer von etwa einer halben Stunde bei 80 bis 90 % relativer Luftfeuchtigkeit.

Gemäß einer besonderen Ausführungsform der vorliegenden Erfindung besteht die Möglichkeit, daß zwei erfindungsgemäße Barrierefolien jeweils über ihre aluminiumoxidbasierte Barriereschicht aufeinandergeschichtet, insbesondere aufeinanderlaminiert, werden. Auf diese Weise resultiert somit ein doppelter Barrierefolienverbund,

Für weitergehende Einzelheiten zu der erfindungsgemäßen Barrierefolie kann auch auf die diesbezüglichen Ansprüche verwiesen werden, in denen weitere, die erfindungsgemäße Barrierefolie näher charakterisierende Eigenschaften wiedergegeben sind.

Die hohen Transparenzwerte bei der erfindungsgemäßen Barrierefolie - in Kombination mit den exzellenten Sperrschichteigenschaften, insbesondere gegenüber Sauerstoff und Wasserdampf sowie gegebenenfalls gegenüber Aromen- lassen sich dadurch erreichen, daß die im Vakuum durchgeführte Plasmabeschichtung der Substratfolie mit der aluminiumoxidbasierten Barriereschicht in besonderer Weise, insbesondere im Rahmen eines mehrstufigen Plasmabeschichtungsprozesses, erfolgt.

Gegenstand der vorliegenden Erfindung - gemäß einem **zweiten** Aspekt der vorliegenden Erfindung - ist somit ein Verfahren zur Herstellung einer wie zuvor beschriebenen transparenten Barrierefolie nach der vorliegenden Erfindung, wobei das Herstellungsverfahren für die erfindungsgemäße transparente Barrierefolie ein mehrstufiges Vakuumplasmabeschichtungsverfahren umfaßt, welches die folgenden Verfahrensschritte in der nachfolgend genannten Reihenfolge aufweist:
(a) Vorbehandeln der Substratfolie mittels Plasmavorbehandlung; dann
(b) Aufbringen einer dünnen, insbesondere weniger als 1 bis 2 nm dicken, unvollständig geschlossenen, ersten Schicht auf Basis von Aluminiumoxid (AlOx) auf mindestens einer Seite der Substratfolie als Starter- oder Bekeimungsschicht für die im nachfolgenden Verfahrensschritt aufzubringende, geschlossene, zweite Schicht auf Basis von Aluminiumoxid (AlOx), insbesondere mittels Magnetronsputtern, vorzugsweise unter Sauerstoffeinlaß; anschließend
(c) Aufbringen einer geschlossenen, zweiten Schicht auf Basis von Aluminiumoxid (A10x) auf die erste, im vorangehenden Verfahrensschritt aufgebrachte Schicht, insbesondere mittels plasmaaktivierten Bedampfens unter Vakuum, so daß eine wie zuvor definierte transparente Barrierefolie resultiert, welche eine Substratfolie aufweist, die auf mindestens einer ihrer beiden Seiten mit einer Barriereschicht auf Basis von Aluminiumoxid (AlOx) versehen ist.

Im Rahmen des erfindungsgemäßen Verfahrens wird also in einem ersten Verfahrensschritt eine extrem dünne, nur weniger als 1 bis 2 nm dicke, im allgemeinen nur unvollständig geschlossene Schicht aus Aluminiumoxid (AlOx) (sogenannte "Bekeimungsschicht" oder "Starterschicht") auf die Substratfolie aufgebracht. Zu diesem Zweck kann die Substratfolie im Vakuum mit Aluminium unter Einlaß von Reaktivgas (Sauerstoff), beispielsweise in einer Bandbedampfungsanlage, bedampft werden derart, daß zunächst eine unvollständig geschlossene Schicht aus Aluminiumoxid durch Magnetronsputtern auf die Substratfolie aufgebracht wird. Erst in dem nachfolgenden zweiten Verfahrensschritt wird dann eine Aluminiumoxidbarriereschicht mit größerer Schichtdicke als geschlossene, kontinuierliche Schicht aufgetragen, so daß letztendlich die gewünschte Schichtdicke der Barriereschicht resultiert.

Im Rahmen des erfindungsgemäßen Verfahrens wird also eine Barrierefolie auf Basis einer wie zuvor beschriebenen aluminumoxidbeschichten (AlOxbeschichteten) Substratfolie erzeugt, wobei die Aluminiumoxidschicht (AlOx-Schicht) zweischichtig ausgebildet ist bzw. aufgebracht wird, wobei die Aluminiumoxidschicht eine erste, untere (d.h. auf die Substratfolie aufgetragene) dünne, insbesondere weniger als 1 bis 2 nm dicke, unvollständig geschlossene Schicht auf Basis von Aluminiumoxid (AlOx) und eine hierauf aufgebrachte, vollständig geschlossene zweite Schicht gleichermaßen auf Basis von Aluminiumoxid (AlOx) aufweist, so daß letztendlich und insgesamt eine einheitliche, kontinuierliche, zusammenhängende und geschlossene Schicht auf dem Substrat resultiert.

Bei dem ersten Verfahrensschritt, bei dem die unvollständig geschlossene Schicht aus Aluminiumoxid auf die Substratfolie aufgebracht wird, erfolgt das Sputtern (Magnetronsputtern) im allgemeinen reaktiv unter Sauerstoffeinlaß. Im allgemeinen kann der Einlaß des Reaktivgases derart erfolgen, daß sich in der Bedampfungszone ein Partialdruckgradient des Reaktivgases einstellt, sich das Mischungsverhältnis zwischen Aluminium, Aluminiumoxid und Sauerstoff in der Barriereschicht als Gradient ausbildet und dieses Mischungsverhältnis in der Barriereschicht ein Maximum des Anteils des metallischen Aluminiums aufweist und die Lage und Ausprägung dieses Maximums in einem bestimmten Tiefenbereich der Barriereschicht durch Variation des Partialdruckgradienten des Reaktivgases und der Lage der Bedampfungszone derart eingestellt wird, daß bei gleicher optischer Transmission der Barriereschicht die Sauerstoffpermeation und/oder die Wasserdampfpermeation ein Minimum erreicht. Das Aluminium kann beispielsweise aus einem sogenannten Schiffchenverdampfer mit mindestens einem Verdampferschiffchen mit kontinuierlicher Aluminiumdrahtzufuhr verdampft werden. Alternativ besteht die Möglichkeit, das Aluminium mittels eines Induktionsverdampfers oder Elektronenstrahlverdampfers zu verdampfen. Im allgemeinen erfolgt die Bedampfung des Substrats plasmaaktiviert. Zur Plasmaaktivierung kann ein Hohlkathodenbogenentladungplasma eingesetzt werden. Beispielsweise können die Plasmaquellen derart betrieben werden, daß sich am Substrat eine durchschnittliche Ionenstromdichte von mindestens 20 mA/cm², insbesondere mindestens 50 mA/m², extrahieren läßt. Auf diese Weise bildet sich eine hauchdünne, weniger als etwa 1 bis 2 nm dicke Aluminiumoxidschicht aus, welche im allgemeinen nicht vollständig geschlossen ist und welche als Bekeimungs- oder Starterschicht für die nachfolgend mit größerer Schichtdicke aufzubringende Aluminiumoxidschicht dient. Der erste Verfahrensschritt kann beispielsweise entsprechend der DE 102 55 822 A1 durchgeführt werden, deren gesamter diesbezüglicher Offenbarungsgehalt hiermit durch Bezugnahme eingeschlossen ist.

Dem ersten Verfahrensschritt schließt sich dann die Aufbringung der kontinuierlichen, geschlossenen, aluminiumoxidbasierten, zweiten Schicht bis zu der vorgenannten Schichtdicke von maximal 100 nm Gesamtdicke (= erste und zweite Schicht) an. Der zweite Verfahrensschritt erfolgt gleichermaßen im allgemeinen mittels plasmaaktivierter Bedampfungstechniken. Im allgemeinen gehen erster und zweiter Verfahrensschritt direkt ineinander über. Der zweite Verfahrensschritt kann beispielsweise entsprechend der DE 196 12 345 C1 und DE 198 45 268 C1 durchgeführt werden, deren gesamter diesbezüglicher Offenbarungsgehalt hiermit durch Bezugnahme eingeschlossen ist.

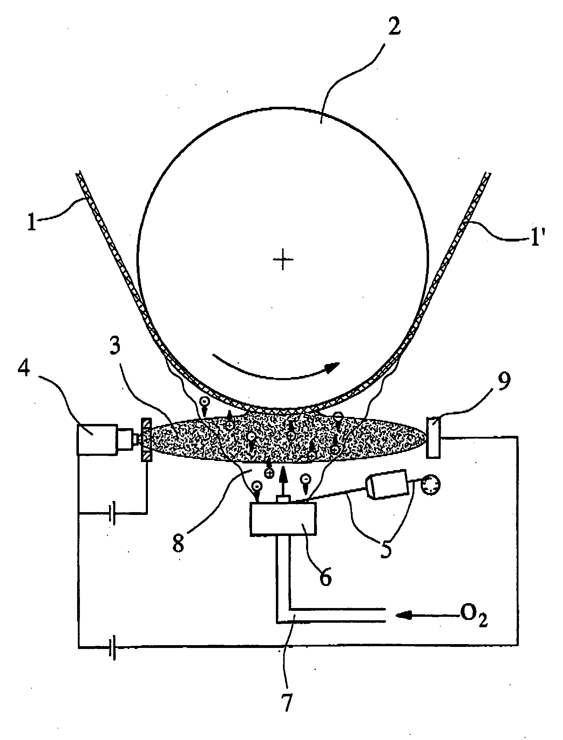

Die einzige Figur zeigt schematisch den erfindungsgemäßen Verfahrensablauf: Eine Substratfolie 1 wird über eine Transportwalze 2 in Pfeilrichtung durch ein reaktives Plasma 3 geführt, so daß letztendlich eine erfindungsgemäße transparente Barrierefolie 1' mit einer aluminiumoxidbeschichteten Barriereschicht resultiert. Die Beschichtungsstation wird mit einem Plasmaerzeuger 4, einer oder mehreren Anoden 9 und einem Sauerstoffzuführungssystem 7 ausgestattet. Das aktive Bauteil des Plasmaerzeugers 4 ist insbesondere eine Hohlkathode. Der Plasmaerzeuger 4 befindet sich vor dem Verdampferschiffchen 6. Die Anodenflächen 9 und die Sauerstoffzuführungsröhrchen 7 sind zwischen den Verdampferschiffchen 6 oder zwischen den Massebolzen angebracht. Für zwei Verdampfer gibt es jeweils einen Plasmaerzeuger 4. Nach Erreichen des Vakuums wird die Hohlkathode erhitzt, bei Erreichen der Betriebstemperatur wird Argon - alternativ auch Stickstoff - zugeführt. Wenn das Plasma stabil ist bzw. gezündet hat, kann die Kathodenheizleistung wieder ausgeschaltet werden. Das Plasma erhält sich dann nachfolgend über den gesamten Beschichtungsprozeß selbst. Das Plasma 3 wird mit Hilfe der Anoden 9 über die Verdampferschiffchen 6 geführt. Hierbei wird der zwischen den Verdampfern eingeblasene Sauerstoff positiv geladen. Der Sauerstoff bewegt sich dadurch mit dem Aluminiumdampf als Gasgemisch 8 in Richtung der negativ geladenen Folie 1. Sobald das Aluminium auf die Folie 1 auftrifft, übernimmt dieses die negative Ladung und reagiert mit dem positiv geladenen Sauerstoff zu Aluminiumoxid (AlOx). Das für den Verdampfungsprozeß benötigte Aluminium 5 kann den Verdampferschiffchen 6 beispielsweise über eine Rolle kontinuierlich zugeführt werden.

So kann beispielsweise das erfindungsgemäße Verfahren wie folgt durchgeführt werden: Eine bandförmige Substratfolie 1 wird in an sich bekannter Weise über eine Transportwalze 2, welche beispielsweise als Kühlwalze ausgebildet sein kann, durch das reaktive Plasma 3 geführt. Unterhalb und senkrecht zur Bewegungsrichtung der Substratfolie 1 können beispielsweise wechselstrombeheizte Verdampferschiffchen 6 angeordnet sein, welchen über eine entsprechende Drahtzuführeinrichtung ständig bzw. kontinuierlich Aluminiumdraht 5 als Verdampfungsmaterial zugeführt wird. Für die reaktive Abscheidung von Aluminiumoxid (AlOx) auf der Substratfolie 1 kann beispielsweise zwischen den Verdampferschiffchen 6 und der Substratfolie 1 ein Düsenrohr 7 zum Einlassen von Sauerstoff als Reaktivgas angeordnet sein. Senkrecht zur Bewegungsrichtung der Substratfolie 1 sind dicht unterhalb der Substratfolie 1 Hohlkathodenbogenquellen, Ringanode, Stromversorgung und magnetische Wechselablenksysteme angeordnet, wobei die Hohlkathodenbogenquellen horizontale, nebeneinander verlaufene Niedervoltelektronenstrahlen in Bewegungsrichtung der Substratfolie 1 erzeugen, welche durch die magnetischen Wechselablenksysteme in horizontaler Richtung senkrecht zur Bewegungsrichtung der Substratfolie 1 abgelenkt werden, so daß ein flächenartiger, homogener, über die Substratbreite ausgedehnter Plasmaschirm 3 in der horizontalen Ebene dicht unter der Substratfolie 1 entsteht, wobei im Bereich des Plasmaschirms 3 sowohl die von den Verdampferschiffchen 6 verdampften Aluminiumatome als auch die über das Düsenrohr 7 eingelassenen Sauerstoffmoleküle angeregt und ionisiert werden, bevor sie auf die Substratfolie 1 auftreffen. Durch die hohe Plasmadichte im Plasmaschirm 3 lädt sich die elektrisch isolierende Oberfläche der Substratfolie 1 auf ein selbst Biaspotential von etwa -15 V auf, durch welches Ionen mit einer Stromdichte von ca. 5 mA/cm² aus dem Plasmaschirm 3 auf diese Substratfolie 1 beschleunigt werden. Durch Anlegen einer positiven Spannung an die Verdampferschiffchen 6 über leistungsstarke Stromversorgungsgeräte werden zwischen dem Plasmaschirm 3 als Kathode und den als Anode dienenden Verdampferschiffchen 6 stromstarke vertikale Plasmaentladungen mit Entladungsströmen in der Größenordnung von 100 A pro Verdampferschiffchen 6 gezündet. Dabei können Gruppen von mehreren Verdampferschiffchen 6 je einem Stromversorgungsgerät zugeordnet sein. Diese stromstarken vertikalen Plasmaentladungen führen zur zusätzlichen Ionisierung von Aluminiumdampf und Sauerstoff im gesamten Bereich zwischen Plasmaschirm 3 und Verdampferschiffchen 6 und zur Beschleunigung der erzeugten positiven Ionen durch die Potentialdifferenz der vertikalen Plasmaentladung in Richtung auf die Substratfolie 1. Auf diese Weise werden auf der Substratfolie Ionenstromdichten bis zu 20 mA/cm² und Ionenenergien bis zu 20 eV erreicht, und es wird eine stengelstrukturfreie Schicht aus Aluminiumoxid abgeschieden.

Bei den zuvor geschilderten speziellen Ausführungsformen wird - wie in der zuvor beschriebenen Weise - jeweils zweistufig vorgegangen, indem zunächst, in einem ersten Verfahrensschritt, eine 1 bis 2 nm dicke, unvollständig geschlossene erste Schicht auf Basis von Aluminiumoxid (AlOx) und nachfolgend, in einem zweiten Verfahrensschritt, eine geschlossene, zweite Schicht auf Basis von Aluminiumoxid (AlOx) auf die erste, im vorangehenden Verfahrensschritt aufgebrachte Schicht aufgebracht wird. Üblicherweise ist die eingesetzte Substratfolie in an sich bekannter Weise plasmavorbehandelt, wodurch eine noch verbesserte bzw. gesteigerte Transparenz des Endprodukts resultiert.

Mit dem erfindungsgemäßen Verfahren lassen sich transparente Hochleistungsbarrierefolien auch in großtechnischem Maßstab herstellen, welche exzellente optische Eigenschaften, insbesondere eine exzellente optische Transmission (Transparenz), mit ausgezeichneten Sperrschichteigenschaften in einem Material vereinen.

Weiterer Gegenstand der vorliegenden Erfindung - gemäß einem weiteren, **dritten** Aspekt der vorliegenden Erfindung - ist die Verwendung der erfindungsgemäßen transparenten Barrierefolie im Bereich der Verpackungsindustrie, insbesondere zu Zwecken der Verpackung von Lebensmitteln.

Weitere Ausgestaltungen, Abwandlungen und Variationen der vorliegenden Erfindung sind für den Fachmann beim Lesen der Beschreibung ohne weiteres erkennbar und realisierbar, ohne daß er dabei den Rahmen der vorliegenden Erfindung verläßt.

Die vorliegende Erfindung wird anhand des nachfolgenden Ausführungsbeispiels veranschaulicht, welches die vorliegende Erfindung jedoch keinesfalls beschränken soll.

### Ausführungsbeispiel:

Eine einschichtige PET-Folie, welche zuvor plasmavorbehandelt worden war, wurde mit dem zuvor beschriebenen zweistufigen Verfahren nach der vorliegenden Erfindung mit einer aluminiumoxidbasierten Barriereschicht versehen. Als Substratfolie diente eine 12 µm dicke PET-Folie.

In einem ersten Verfahrensschritt wurde eine weniger als 1 bis 2 nm dicke Aluminiumoxidschicht auf dem Substratfilm erzeugt, wobei die Aluminiumoxidschicht eine unvollständig geschlossene Schicht auf dem Substrat bildete und als Bekeimungs- oder Starterschicht für die nachfolgend aufzubringende, vollständig geschlossene, kontinuierliche aluminiumoxidbasierte Schicht diente. Die unvollständig geschlossene Schichtbildung erfolgte durch Magnetronsputtern auf das Substrat, wobei das Sputtern reaktiv unter Sauerstoffeinlaß entsprechend der DE 102 55 822 A1 erfolgte.

Nachfolgend wurde dann entsprechend der DE 196 12 345 C1 und der DE 198 45 268 C1 die Plasmabehandlung auf der Bekeimungsschicht weitergeführt, bis eine geschlossene, gleichmäßig dichte, einige zehn Nanometer dicke aluminiumoxidbasierte Barriereschicht auf dem Substratfilm gebildet worden war.

Zu diesem Zweck wurde ein Verfahren zum plasmaaktivierten Bedampfen mit hohen Durchsätzen angewandt, wobei die Substratfolie horizontal über eine Verdampfereinrichtung bewegt wurde und zwischen Verdampfereinrichtung und Substratfolie ein Plasma erzeugt wurde, wobei durch mehrere horizontal nebeneinander verlaufenden Niedervoltelektronenstrahlen dicht unter dem Substrat ein horizontal über die gesamte Substratbreite ausgedehnter, flächenartiger Plasmaschirm hoher Dichte erzeugt wurde und wobei zwischen diesem als Kathode beschalteten horizontalen Plasmaschirm und der als Anode beschalteten Verdampfereinrichtung mehrere vertikale Plasmaentladungen gezündet wurden.

Zur Bildung des flächenartigen Plasmaschirms wurden die Niedervoltelektronenstrahlen in Hohlkathodenbogenquellen erzeugt. Ein horizontales Magnetfeld zur Führung der Niedervoltelektronenstrahlen und Erhöhung der Potentialdifferenz der vertikalen Plasmaentladungen mit einer Feldstärke von mehr als 0,5 kA/m zwischen Verdampfereinrichtung und Substrat wurde erzeugt, wobei dessen Feldlinien in Richtung der Niedervoltelektronenstrahlen verliefen. Zur Erzielung einer homogenen Plasmadichte des Plasmaschirms senkrecht zur Bewegungsrichtung des Substrats wurden die horizontalen Niedervoltelektronenstrahlen durch magnetische Wechselfelder von magnetischen Wechselablenksystemen mit Ablenkfrequenzen von vorzugsweise 50 Hz bis 5 kHz abgelenkt. Zur Erzielung einer homogenen Plasmadichte des Plasmaschirms senkrecht zur Bewegungsrichtung des Substrats beim Bedampfen mit wechselstrombeheizten Schiffchenverdampfern wurden die horizontalen Niedervoltelektronenstrahlen durch die von den Heizströmen erzeugten Wechselmagnetfeldem abgelenkt. Im Bereich der vertikalen Plasmaentladung wurde ein inhomogenes, in Richtung zum Substrat divergierendes, vertikales Magnetfeld zur Führung der Niedervoltelektronenstrahlen und Erhöhung der Potentialdifferenz der vertikalen Plasmaentladung mit Feldstärken zwischen 0,5 und 50 kA/m erzeugt.

Es resultierte eine erfindungsgemäße transparente Barrierefolie mit einer einseitig aufgebrachten aluminiumoxidbasierten Barriereschicht, welche eine optische Transmission bei etwa 500 nm, bestimmt nach ASTM D1746-03, von mehr als 99 % aufwies.

Nachfolgend wurden die Sperrschichteigenschaften in bezug auf Wasserdampfdurchlässigkeit und Sauerstoffdurchlässigkeit bestimmt.

Die angegebenen Wasserdampfdurchlässigkeiten wurden nach DIN 53122/II bei 23 °C und 85 % relativer Luftfeuchtigkeit bestimmt, und die betreffenden Werte sind in "g/m² ·24 h" angegeben. Die Sauerstoffdurchlässigkeiten wurden nach DIN 53380/II bei 23°C und 50 % relativer Luftfeuchtigkeit bestimmt, und die betreffenden Werte sind in "cm³/m². 24 h" angegeben.

Die folgenden Werte wurden erhalten:

| O₂-Durchlässigkeit: | |
|---|---|
| 1, Messung | 2. Messung |
| 2,52 | 2,28 |
| 1,02 | 1,68 |
| 1,79 | 2,02 |
| 1,87 | 1,58 |

| Wasserdampfdurchlässigkeit: | |
|---|---|
| 1. Messung | 2. Messung |
| 0,66 | 0,62 |
| 0,69 | 0,70 |
| 0,53 | 0,55 |
| 0,58 | 0,57 |
| 0,57 | 0,52 |

Das vorangehende Ausführungsbeispiel wird wiederholt, jedoch mit dem Unterschied, daß die eingesetzte einschichtige PET-Folie zuvor nicht plasmavorbehandelt worden war. Es resultierte gleichermaßen eine erfindungsgemäße transparente Barrierefolie mit einer einseitig aufgebrachten aluminiumoxidbasierten Barriereschicht, welche eine optische Transmission bei etwa 500 nm, bestimmt nach ASTM D1746-03, von mehr als etwa 98 % aufwies. Im Vergleich zu dem vorangehenden Versuch war jedoch die optische Transmission geringfügig schlechter (aber absolut immer noch ausgezeichnet), was auf das Auslassen bzw. Fehlen der Plasmavorbehandlung zurückzuführen ist. Durch Plasmavorbehandlung der eingesetzten Substratfolie lassen sich somit die optischen Transmissionseigenschaften noch weiter steigern.

Nach dem erfindungsgemäßen Verfahren resultieren somit transparente Barrierefolien, welche ausgezeichnete optische Transparenzeigenschaften mit ausgezeichneten Sperrschichteigenschaften gegenüber Wasserdampf- und Sauerstoffdurchlässigkeit in einem einzigen Material miteinander vereinen.

## Patentansprüche

1. Transparente Barrierefolie, insbesondere zur Verpackung von Lebensmitteln, wobei die Barrierefolie eine Substratfolie aufweist, die auf mindestens einer ihrer beiden Seiten mit einer Barriereschicht auf Basis von Aluminiumoxid (AlOx) versehen ist,
wobei die Substratfolie auf Basis mindestens eines thermoplastischen Polymers, ausgewählt aus der Gruppe von Polyethylenterephthalat (PET), Polyolefinen und Polylactiden (Polymilchsäuren, PLA) sowie deren Mischungen und Kombinationen, ausgebildet ist,
wobei die Barrierefolie Sperrschichteigenschaften gegenüber Wasserdampf und Sauerstoff aufweist, wobei die Barrierefolie eine Wasserdampfdurchlässigkeit im Bereich von 1/5 bis 1/500 der Wasserdampfdurchlässigkeit der unbeschichteten Substratfolie und eine Sauerstoffdurchlässigkeit im Bereich von 1/5 bis 1/500 der Sauerstoffdurchlässigkeit der unbeschichteten Substratfolie aufweist,
wobei die Barrierefolie eine optische Transmission (Transparenz) bei einer Wellenlänge im Bereich von 400 bis 600 nm, insbesondere bei etwa 500 nm, von mindestens 96 % aufweist und
wobei die aluminiumoxidbasierte Barriereschicht abriebfest mit der unterliegenden Substratfolie verbunden ist, wobei die Schälkraft der aluminiumoxidbasierten Barriereschicht zu der unterliegenden Substratfolie mindestens 0,4 N/15 mm beträgt.

2. Barrierefolie nach Anspruch 1, **dadurch gekennzeichnet, daß** die Barrierefolie eine optische Transmission (Transparenz) bei einer Wellenlänge im Bereich von 400 bis 600 nm, insbesondere bei etwa 500 nm, von mindestens 97 %, vorzugsweise mindestens 98 %, besonders bevorzugt mindestens 99 %, aufweist und/oder daß die Dicke der aluminiumoxidbasierten Barriereschicht im Bereich von 1 bis 100 nm, insbesondere 2 bis 75 nm, vorzugsweise 3 bis 50 nm, besonders bevorzugt 5 bis 40 nm, variiert,

3. Barrierefolie nach Anspruch 1 oder 2, **dadurch gekennzeichnet, daß** die aluminiumoxidbasierte Barriereschicht weniger als 5 Gew.-%, insbesondere weniger als 4 Gew.-%, vorzugsweise weniger als 3 Gew.-%, besonders bevorzugt weniger als 2 Gew.-%, ganz besonders bevorzugt weniger als 1 Gew.-%, bezogen auf das Gesamtgewicht der Barrierefolie, ausmacht.

4. Barrierefolie nach einem der vorangehenden Ansprüche, **dadurch gekennzeichnet, daß** die aluminiumoxidbasierte Barriereschicht durch Bedampfen auf die Substratfolie, insbesondere mittels Vakuumplasmabeschichtung, aufgebracht ist und/oder daß die aluminiumoxidbasierte Barriereschicht eine zumindest im wesentlichen gleichmäßige, insbesondere gleichmäßig dicke und/oder gleichmäßig dichte, kontinuierliche, geschlossene Schicht auf der Substratfolie ausbildet.

5. Barrierefolie nach einem der vorangehenden Ansprüche, **dadurch gekennzeichnet, daß** die Schälkraft der aluminiumoxidbasierten Barriereschicht zu der unterliegenden Substratfolie, insbesondere im feuchten Zustand, im Bereich von 0,4 bis 20 N/15 mm, vorzugsweise 0,6 bis 16 N/15 mm, besonders bevorzugt 1 bis 10 N/15 mm, liegt.

6. Barrierefolie nach einem der vorangehenden Ansprüche, **dadurch gekennzeichnet, daß** die aluminiumoxidbasierte Barriereschicht auf ihrer von der Substratfolie abgewandten Seite mit einer Schutz- oder Versiegelungsschicht, insbesondere in Form eines Lacks, eines Primers oder einer Folie, versehen ist,

7. Barrierefolie nach einem der vorangehenden Ansprüche, **dadurch gekennzeichnet, daß** die Barrierefolie eine Wasserdampfdurchlässigkeit aufweist, welche einem Wert im Bereich von 1/10 bis 1/200, vorzugsweise 1/10 bis 1/100, der Wasserdampfdurehlässigkeit der unbeschichteten Substratfolie entspricht, und/oder daß die Barrierefolie eine Sauerstoffdurchlässigkeit aufweist, welche einem Wert im Bereich von 1/10 bis 1/200, vorzugsweise 1/10 bis 1/100, der Sauerstoffdurchlässigkeit der unbeschichteten Substratfolie entspricht.

8. Barrierefolie nach einem der vorangehenden Ansprüche, **dadurch gekennzeichnet, daß** die Substratfolie eine Dicke im Bereich von 1 bis 100 µm, insbesondere 2,5 bis 75 µm, vorzugsweise 5 bis 50 µm, besonders bevorzugt 6 bis 25 µm, ganz besonders bevorzugt 7 bis 22 µm, aufweist.

9. Barrierefolie nach einem der vorangehenden Ansprüche **dadurch gekennzeichnet, daß** die Substratfolie eine PET-Folie ist.

10. Barrierefolie nach Anspruch 9, **dadurch gekennzeichnet, daß** die Substratfolie eine PET-Folie ist,
• wobei die PET-Folie eine Zugfestigkeit in mindestens Quer- oder Längsrichtung, vorzugsweise in Quer- und Längsrichtung, bestimmt nach DIN 53455 bei 23 °C und 50 % relativer Luftfeuchtigkeit, von wenigstens 100 N/mm², insbesondere wenigstens 150 N/mm², bevorzugt wenigstens 200 N/mm², ganz besonders bevorzugt wenigstens 220 N/mm², aufweist; und/oder
• wobei die PET-Folie eine Reißdehnung in mindestens Quer- oder Längsrichtung, vorzugsweise in Quer- und Längsrichtung, bestimmt nach DIN 53455 bei 23 °C und 50 % relativer Luftfeuchtigkeit, von wenigstens 80 %, insbesondere wenigstens 85 %, bevorzugt wenigstens 90 %, ganz besonders bevorzugt wenigstens 100 %, aufweist; und/oder
• wobei die PET-Folie eine Dichte, bestimmt nach ASTM D1505-68, Methode C, bei 23 °C von 1,2 bis 1,4 g/cm³, insbesondere etwa 1,3 g/cm³, ganz besonders bevorzugt etwa 1,395 g/cm³, aufweist; und/oder
• wobei die PET-Folie eine Dicke im Bereich von 1 bis 100 µm, insbesondere 2,5 bis 75 µm, vorzugsweise 5 bis 50 µm, besonders bevorzugt 6 bis 25 µm, ganz besonders bevorzugt 7 bis 22 µm, aufweist.

11. Barrierefolie nach Anspruch 9 oder 10, **dadurch gekennzeichnet, daß** die Substratfolie als eine einschichtige PET-Folie ausgebildet ist oder aber daß die Substratfolie als eine mehrschichtige PET-Folie ausgebildet, insbesondere wobei die mehrschichtige PET-Folie mindestens drei PET-Lagen, vorzugsweise drei bis sieben PET-Lagen, umfaßt, welche miteinander verbunden, insbesondere laminiert oder coextrudiert, sind und/oder insbesondere wobei die unterschiedlichen PET-Lagen zumindest teilweise aus unterschiedlichen PET-Typen und/oder unterschiedlichen PET-Zusammensetzungen und/oder unterschiedlichen PET-Qualitäten gebildet sind.

12. Barrierefolie nach einem der Ansprüche 9 bis 11, **dadurch gekennzeichnet,**
**daß** die Barrierefolie eine Wasserdampfdurchlässigkeit, bestimmt nach DIN 53122/II bei 23 °C und bei 85 % relativer Luftfeuchtigkeit, von weniger als 10 g/m²·24 h, insbesondere weniger als 5 g/m² · 24 h, vorzugsweise weniger als 4 g/m² · 24 h, bevorzugt weniger als 3 g/m² · 24 h, besonders bevorzugt weniger als 2 g/m² · 24 h, aufweist und/oder
**daß** die Barrierefolie eine Sauerstoffdurchlässigkeit, bestimmt nach DIN 53380/II bei 23 °C und bei 50 % relativer Luftfeuchtigkeit, von weniger als 10 cm³/m² · 24 h, insbesondere weniger als 5 cm³/m² · 24 h, vorzugsweise weniger als 4 cm^{3/}m² · 24 h, bevorzugt weniger als 3 cm³/m² · 24 h, aufweist.

13. Barrierefolie nach einem der Ansprüche 1 bis 8, **dadurch gekennzeichnet, daß** die Substratfolie eine Polyolefinfolie, insbesondere eine Polypropylenfolie, vorzugsweise eine gereckte Polypropylenfolie (OPP-Folie), besonders bevorzugt eine biaxial gereckte Polypropylenfolie (BOPP-Folie), ist.

14. Barrierefolie nach Anspruch 13, **dadurch gekennzeichnet, daß** die Substratfolie eine Polyolefinfolie, insbesondere eine Polypropylenfolie, vorzugsweise eine gereckte Polypropylenfolie (OPP-Folie), besonders bevorzugt eine biaxial gereckte Polypropylenfolie (BOPP-Folie), ist,
• wobei die Polyolefinfolie eine Zugfestigkeit in mindestens Quer- oder Längsrichtung, vorzugsweise in Quer- und Längsrichtung, bestimmt nach DIN 53455 bei 23 °C und 50 % relativer Luftfeuchtigkeit, von wenigstens 100 N/mm², insbesondere wenigstens 150 N/mm², bevorzugt wenigstens 200 N/mm² ganz besonders bevorzugt wenigstens 300 N/mm², aufweist; und/oder
• wobei die Polyolefinfolie eine Reißdehnung in mindestens Quer- oder Längsrichtung, vorzugsweise in Quer- und Längsrichtung, bestimmt nach DIN 53455 bei 23 °C und 50 % relativer Luftfeuchtigkeit, von wenigstens 60 %, insbesondere wenigstens 100 %, bevorzugt wenigstens 125 %, ganz besonders bevorzugt wenigstens 150 %, aufweist; und/oder
• wobei die Polyolefinfolie eine Dichte, bestimmt nach ASTM D1505-68, Methode C, bei 23 °C von 0,85 bis 0,95 g/cm³, insbesondere etwa 0,9 g/cm³, ganz besonders bevorzugt etwa 0,91 g/cm³, aufweist; und/oder
• wobei die Polyolefinfolie eine Dicke im Bereich von 1 bis 100 µm, insbesondere 2,5 bis 75 µm, vorzugsweise 5 bis 50 µm, besonders bevorzugt 10 bis 30 µm, ganz besonders bevorzugt 12 bis 25 µm, aufweist.

15. Barrierefolie nach Anspruch 13 oder 14, **dadurch gekennzeichnet, daß** die Substratfolie als eine einschichtige Polyolefinfolie ausgebildet ist oder aber daß die Substratfolie eine mehrschichtige Polyolefinfolie ausgebildet, insbesondere wobei die mehrschichtige Polyolefinfolie mindestens drei Polyolefinlagen, vorzugsweise drei bis sieben Polyolefinlagen, umfaßt, welche miteinander verbunden, insbesondere laminiert oder coextrudiert, sind und/oder insbesondere wobei die unterschiedlichen Polyolefinlagen zumindest teilweise aus unterschiedlichen Polyolefintypen und/oder unterschiedlichen Polyolefinzusammensetzungen und/oder unterschiedlichen Polyolefinqualitäten gebildet sind.

16. Barrierefolie nach einem der Ansprüche 13 bis 15, **dadurch gekennzeichnet,**
**daß** die Barrierefolie eine Wasserdampfdurchlässigkeit, bestimmt nach DIN 53122/II bei 23 °C und bei 85 % relativer Luftfeuchtigkeit, von weniger als 10 g/m² · 24 h, insbesondere weniger als 5 g/m² · 24 h, vorzugsweise weniger als 3 g/m² · 24 h, bevorzugt weniger als 2 g/m² · 24 h, besonders bevorzugt weniger als 1 g/m² · 24 h, aufweist und/oder
**daß** die Barrierefolie eine Sauerstoffdurchlässigkeit, bestimmt nach DIN 53380/II bei 23 °C und bei 50 % relativer Luftfeuchtigkeit, von weniger als 100 cm³/m² · 24 h, insbesondere weniger als 90 cm³/m² · 24 h, vorzugsweise weniger als 80 cm³/m² · 24 h, bevorzugt weniger als 70 cm³/m² · 24 h, besonders bevorzugt weniger als 60 cm³/m² · 24 h, ganz besonders bevorzugt weniger als 50 cm³/m² · 24 h, aufweist.

17. Barrierefolie nach einem der vorangehenden Ansprüche, **dadurch gekennzeichnet, daß** die Barrierefolie sterilisierfest ist, insbesondere bei Temperaturen im Bereich von 100 bis 130 °C über eine Dauer von etwa einer halben Stunde bei 80 bis 90 % relativer Luftfeuchtigkeit und/oder daß zwei Barrierefolien jeweils über ihre aluminiumoxidbasierte Barriereschicht aufeinandergeschichtet, insbesondere aufeinanderlaminiert, sind.

18. Verfahren zur Herstellung einer transparenten Barrierefolie, wie in einem der vorangehenden Ansprüche definiert, **gekennzeichnet durch** ein mehrstufiges Vakuumplasmabeschichtungsverfahren, welches die folgenden Verfahrensschritte in der nachfolgend genannten Reihenfolge umfaßt:
(a) Vorbehandeln der Substratfolie mittels Plasmavorbehandlung; dann
(b) Aufbringen einer dünnen, insbesondere weniger als 1 bis 2 nm dicken, unvollständig geschlossenen ersten Schicht auf Basis von Aluminiumoxid (AlOx) auf mindestens einer Seite der Substratfolie als Starter- oder Bekeimungsschicht für die im nachfolgenden Verfahrensschritt aufzubringende, geschlossene, zweite Schicht auf Basis von Aluminiumoxid (AlOx), insbesondere mittels Magnetronsputtern, vorzugsweise unter Sauerstoffeinlaß; anschließend
(c) Aufbringen einer geschlossenen, zweiten Schicht auf Basis von Aluminiumoxid (AlOx) auf die erste, im vorangehenden Verfahrensschritt aufgebrachte Schicht, insbesondere mittels plasmaaktivierten Bedampfens unter Vakuum, so daß eine wie in den vorangehenden Ansprüchen definierte transparente Barrierefolie resultiert, welche eine Substratfolie aufweist, die auf mindestens einer ihrer beiden Seiten mit einer Barriereschicht auf Basis von Aluminiumoxid (AlOx) versehen ist.

19. Verwendung einer transparenten Barrierefolie, wie in einem der vorangehenden Ansprüche definiert, im Bereich der Verpackungsindustrie, insbesondere zu Zwecken der Verpackung von Lebensmitteln.

## Claims

1. A transparent barrier film, in particular for packaging foods, wherein the barrier film has a substrate film, which is provided with a barrier layer based on aluminum oxide (AlOx) on at least one of its two sides,
wherein the substrate film is designed based on at least one thermoplastic polymer selected from the group of polyethylene terephthalate (PET), polyolefins and polylactides (polylactic acid, PLA) as well as mixtures and combinations thereof,
wherein the barrier film has barrier layer properties with respect to water vapor and oxygen, wherein the barrier film has a water vapor permeability in the range of 1/5 to 1/500 of the water vapor permeability of the uncoated substrate film and has an oxygen permeability in the range of 1/5 to 1/500 of the oxygen permeability of the uncoated substrate film,
wherein the barrier film has an optical transmission (transparency) of at least 96 % at a wavelength in the range of 400 to 600 nm, in particular at approximately 500 nm, and
wherein the barrier layer based on aluminum oxide is connected to the underlying substrate film in an abrasion-resistant manner, wherein the peel force of the barrier layer based on aluminum oxide to the underlying substrate film amounts to at least 0.4 N/15 mm.

2. The barrier film according to Claim 1, **characterized in that** the barrier film has an optical transmission (transparency), of at least 97 % at a wavelength in the range of 400 to 600 nm, in particular at approximately 500 nm, preferably at least 98 %, especially preferably at least 99 %, and/or the thickness of the barrier layer based on aluminum oxide is varied in the range of 1 to 100 nm, in particular 2 to 75 nm, preferably 3 to 50 nm, especially preferably 5 to 40 nm.

3. The barrier film according to Claim 1 or 2, **characterized in that** the barrier layer based on aluminum oxide constitutes less than 5 wt %, in particular less than 4 wt %, preferably less than 3 wt %, especially preferably less than 2 wt %, most especially preferably less than 1 wt %, based on the total weight of the barrier film.

4. The barrier film according to any one of the preceding claims, **characterized in that** the barrier layer based on aluminum oxide is applied to the substrate film by vapor deposition, in particular by means of a vacuum plasma coating, and/or the barrier layer based on aluminum oxide forms an at least essentially uniform, in particular uniformly thick and/or uniformly dense, continuous, closed layer on the substrate film.

5. The barrier film according to any one of the preceding claims, **characterized in that** the peel force of the barrier layer based on aluminum oxide to the underlying substrate film, in particular in a moist condition, is in the range of 0.4 to 20 N/15 mm, preferably 0.6 to 16 N/15 mm, especially preferably 1 to 10 N/15 mm.

6. The barrier film according to any one of the preceding claims, **characterized in that** the barrier layer based on aluminum oxide is provided with a protective or sealing layer, in particular in the form of the lacquer, a primer or a film on its side facing away from the substrate film.

7. The barrier film according to any one of the preceding claims, **characterized in that** the barrier film has a water vapor permeability corresponding to a value in the range of 1/10 to 1/200, preferably 1/10 to 1/100 of the water vapor permeability of the uncoated substrate film and/or the barrier film has an oxygen permeability corresponding to a value in the range of 1/10 to 1/200, preferably 1/10 to 1/100 of the oxygen permeability of the uncoated substrate film.

8. The barrier film according to any one of the preceding claims, **characterized in that** the substrate film has a thickness in the range of 1 to 100 µm, in particular 2.5 to 75 µm, preferably 5 to 50 µm, especially preferably 6 to 25 µm, most especially preferably 7 to 22 µm.

9. The barrier film according to any one of the preceding claims, **characterized in that** the substrate film is a PET film.

10. The barrier film according to Claim 9, **characterized in that** the substrate film is a PET film,
• wherein the PET film has a tensile strength of at least 100 N/mm² in at least the transverse or longitudinal direction, preferably in both transverse and longitudinal directions, determined according to DIN 53455 at 23 °C and 50 % relative atmospheric humidity, in particular at least 150 N/mm², preferably at least 200 N/mm², most especially preferably at least 220 N/mm²; and/or
• wherein the PET film has a tensile elongation of at least 80 % in at least the transverse or longitudinal direction, preferably in both the transverse and longitudinal directions, determined according to DIN 53455 at 23 °C and 50 % relative atmospheric humidity, in particular at least 85 %, preferably at least 90 %, most especially preferably at least 100 %; and/or
• wherein the PET film has a density of 1.2 to 1.4 g/cm³, determined according to ASTM D1505-68, method C, at 23 °C, in particular approximately 1.3 g/cm³, most especially preferably approximately 1.395 g/cm³; and/or
• wherein the PET film has a thickness in the range of 1 to 100 µm, in particular 2.5 to 75 µm, preferably 5 to 50 µm, especially preferably 6 to 25 µm, most especially preferably 7 to 22 µm.

11. The barrier film according to Claim 9 or 10, **characterized in that** the substrate film is embodied as a single-layer PET film or the substrate film is embodied as a multilayer PET film in particular, wherein the multilayer PET film comprises at least three PET layers, preferably three to seven PET layers which are bonded together, in particular laminated or coextruded and/or in particular wherein the different PET layers are formed at least partially of different types of PET and/or different PET compositions and/or different PET qualities.

12. The barrier film according to any one of Claims 9 to 11, **characterized in that**
the barrier film has a water vapor permeability, determined according to DIN 53122/II at 23 °C and at 85 % relative atmospheric humidity of less than 10 g/m²·24 h, in particular less than 5 g/m²·24 h, preferably less than 4 g/m²·24 h, preferably less than 3 g/m²·24 h, especially preferably less than 2 g/m²·24 h, and/or
the barrier film has an oxygen permeability of less than 10 cm³/m²·24 h, determined according to DIN 53380/II at 23 °C and at 50 % relative atmospheric humidity, in particular less than 5 cm³/m²·24 h, preferably less than 4 cm³/m²·24 h, especially preferably less than 3 cm³/m²·24 h.

13. The barrier film according to any one of Claims 1 to 8, **characterized in that** the substrate film is a polyolefin film, in particular a polypropylene film, preferably an oriented polypropylene film (OPP film), especially preferably a biaxially oriented polypropylene film (BOPP film).

14. The barrier film according to Claim 13, **characterized in that** the substrate film is a polyolefin film, in particular a polypropylene film, preferably an oriented polypropylene film (OPP film), especially preferably a biaxially oriented polypropylene film (BOPP film),
• wherein the polyolefin film has a tensile strength in at least the transverse or longitudinal direction, preferably in both the transverse and longitudinal directions, determined according to DIN 53455 at 23 °C and 50 % relative atmospheric humidity, of at least 100 N/mm², in particular at least 150 N/mm², preferably at least 200 N/mm², most especially preferably at least 300 N/mm², and/or
• wherein the polyolefin film has a tensile elongation in at least the transverse or longitudinal direction, preferably in both the transverse and longitudinal directions, determined according to DIN 53455 at 23 °C and 50 % relative atmospheric humidity, of at least 60 %, in particular at least 100 %, preferably at least 125 %, most especially preferably at least 150 %; and/or
• wherein the polyolefin film has a density of 0.85 to 0.95 g/cm³, determined according to ASTM DI505-68, method C at 23 °C, in particular approximately 0.9 g/cm³, most especially preferably approximately 0.91 g/cm³ and/or
• wherein the polyolefin film has a thickness in the range of 1 to 100 µm, in particular 2.5 to 75 µm, preferably 5 to 50 µm, especially preferably 10 to 30 µm, most especially preferably 12 to 25 µm,

15. The barrier film according to Claim 13 or 14, **characterized in that** the substrate film is embodied as a single-layer polyolefin film or the substrate film is embodied as a multilayer polyolefin film, in particular wherein the multilayer polyolefin film has at least three polyolefin layers, preferably three to seven polyolefin layers, which are bonded to one another in particular by laminating or coextrusion, and/or in particular wherein the different polyolefin layers are formed at least partially from different types of polyolefin and/or different polyolefin compositions and/or different polyolefin qualities.

16. The barrier film according to any one of Claims 13 to 15, **characterized in that**
the barrier film has a water vapor permeability, determined according to DIN 53122/II at 23 °C and 80 % relative atmospheric humidity, of less than 10 g/m²·24 h, in particular less than 5 g/m²·24 h, preferably less than 3 g/m²·24 h, preferably less than 2 g/m²·24 h, especially preferably less than 1 g/m²·24 h, and/or
the barrier film has an oxygen permeability, determined according to DIN 53380/II at 23 °C and at 50 % relative atmospheric humidity of less than 100 cm³/m²·24 h, in particular less than 90 cm³/m²·24 h, preferably less than 80 cm³/m²·24 h, preferably less than 70 cm³/m²·24 h, preferably less than 60 cm³/m²·24 h, most especially preferably less than 50 cm³/m²·24 h.

17. The barrier film according to any one of the preceding claims, **characterized in that** the barrier film is sterilizable, in particular at temperatures in the range of 100 to 130 °C for period of approximately half an hour at 80 to 90 % relative atmospheric humidity and/or two barrier films are each layered onto the other via its barrier layer based on aluminum oxide, in particular being laminated to one another.

18. A method for producing a transparent barrier film as defined in any one of the preceding claims, **characterized by** a multistage vacuum plasma coating, comprising the following method steps in the order given below:
(a) pretreating the substrate film by means of a plasma pretreatment; then
(b) applying a thin incompletely closed first layer, in particular less than 1 to 2 nm thick, based on aluminum oxide (AlOx) on at least one side of the substrate film as the starter or lining layer for the closed second layer based on aluminum oxide (AlOx) which is to be applied in the subsequent method step, in particular by means of magnetron sputtering, preferably with the admission of oxygen; then
(c) applying a closed second layer based on aluminum oxide (AlOx*) to the first layer applied in the preceding process step, in particular by means of plasma-activated vapor deposition *in vacuo*, so that a transparent barrier film as defined in the preceding claims is the result, having a substrate film which is provided with a barrier layer based on aluminum oxide (AlOx) on at least one of its two sides.

19. Use of a transparent barrier film as defined in any one of the preceding claims in the area of the packaging industry, in particular for the purposes of packaging foodstuffs.

## Revendications

1. Film barrière transparent, notamment pour l'emballage de produits alimentaires, le film barrière comportant un film substrat, qui sur au moins l'une de ses faces est muni d'une couche formant barrière sur base d'oxyde d'aluminium (AlOx),
le film substrat étant conçu sur la base d'au moins un polymère thermoplastique, choisi dans le groupe du polyéthylène téréphtalate (PET), des polyoléfines et des polylactides (polyacides lactiques, PLA), ainsi que de leurs mélanges et associations,
le film barrière présentent des propriétés de couche de barrage contre la vapeur d'eau et l'oxygène, le film barrière présentant une perméabilité à la vapeur d'eau de l'ordre de 1/5 à 1/500 de la perméabilité à la vapeur d'eau du film substrat non revêtu et une perméabilité à l'oxygène de l'ordre de 1/5 à 1/500 du film substrat non revêtu,
le film barrière présentant une transmission optique (transparence) à une longueur d'ondes de l'ordre de 400 à 600 nm, notamment à environ 500 nm d'au moins 96 % et
la couche barrière sur base oxyde d'aluminium étant reliée de manière résistant à l'abrasion avec le film substrat sous-jacent, la force de pelage de la couche barrière sur base d'oxyde d'aluminium par rapport à la couche substrat sous-jacente étant d'au moins 0,4 N/15 mm.

2. Film barrière selon la revendication 1, **caractérisé en ce que** le film barrière présente une transmission optique (transparence) à une longueur d'ondes de l'ordre de 400 à 600 nm, notamment à environ 500 nm d'au moins 97 %, de préférence d'au moins 98 %, de manière particulièrement préférée d'au moins 99 % et/ou **en ce que** l'épaisseur de la couche barrière sur base d'oxyde d'aluminium varie dans la gamme de 1 à 100 nm, notamment de 2 à 75 nm, de préférence de 3 à 50 nm, de manière particulièrement préférée de 5 à 40 nm.

3. Film barrière selon la revendication 1 ou 2, **caractérisé en ce que** la couche barrière sur base d'oxyde d'aluminium correspond à moins de 5 % en poids, notamment à moins de 4 % en poids, de préférence à moins de 3 % en poids, de manière particulièrement préférée à moins de 2 % en poids, de manière tout particulièrement préférée à moins de 1 % en poids en rapport au poids total du film barrière.

4. Film barrière selon l'une quelconque des revendications précédentes, **caractérisé en ce que** la couche barrière sur base d'oxyde d'aluminium est appliquée par vaporisation sur le film substrat, notamment par revêtement sous vide par plasma et/ou **en ce que** la couche barrière sur base d'oxyde d'aluminium forme sur le film substrat une couche continue close, d'une épaisseur sensiblement régulière, notamment régulière et/ou d'une densité régulière.

5. Film barrière selon l'une quelconque des revendications précédentes, **caractérisé en ce que** la force de pelage de la couche barrière sur base d'oxyde d'aluminium par rapport au film substrat sous-jacent, notamment à l'état humide est de l'ordre de 0,4 à 20 N/15 mm, de préférence de 0,6 à 16 N/15 mm, de manière particulièrement préférée de 1 à 10 N/15 mm,

6. Film barrière selon l'une quelconque des revendications précédentes, **caractérisé en ce que** sur son côté opposé au film substrat, la couche barrière sur base d'oxyde d'aluminium est munie d'une couche protectrice ou d'une couche de scellement, notamment sous la forme d'une laque, d'une couche de fond ou d'un film.

7. Film barrière selon l'une quelconque des revendications précédentes, **caractérisé en ce que** le film barrière présente une perméabilité à la vapeur d'eau, qui correspond à une valeur de l'ordre de 1/10 à 1/200, de préférence de 1/10 à 1/100 de la perméabilité à la vapeur d'eau du film substrat non revêtu et/ou **en ce que** le film barrière présente une perméabilité à l'oxygène qui correspond à une valeur de l'ordre de 1/10 à 1/200, de préférence de 1/10 à 1/100 de la perméabilité à l'oxygène du film substrat non revêtu.

8. Film barrière selon l'une quelconque des revendications précédentes, **caractérisé en ce que** le film substrat présente une épaisseur de l'ordre de 1 à 100 µm, notamment de 2,5 à 75 µm, de préférence de 5 à 50 µm, de manière particulièrement préférée de 6 à 25 µm, de manière tout particulièrement préférée de 7 à 22 µm.

9. Film barrière selon l'une quelconque des revendications précédentes, **caractérisé en ce que** le film substrat est un film en PET.

10. Film barrière selon la revendication 9, **caractérisé en ce que** le film substrat est un film en PET,
• le film en PET présentant une résistance à la traction au moins en direction transversale ou longitudinale, de préférence en direction transversale et longitudinale, déterminée selon la norme DIN 53455 à 23° C et à 50 % d'humidité relative de l'air d'au moins 100 N/mm², notamment d'au moins 150 N/mm², de préférence d'au moins 200 N/mm², de manière tout particulièrement préférée d'au moins 220 N/mm²; et/ou
• le film en PET présentant une élongation à la rupture au moins en direction transversale ou longitudinale, de préférence en direction transversale et longitudinale, déterminée selon la norme DIN 53455 à 23° C et à 50 % d'humidité relative de l'air d'au moins 80 %, notamment d'au moins 85 %, de préférence d'au moins 90 %, de manière tout particulièrement préférée d'au moins 100 %; et/ou
• le film en PET présentent une densité déterminée selon ASTM D1505-68, méthode C, à 23° C de 1,2 à 1,4 g/cm³, notamment d'environ 1,3 g/cm³, de manière tout particulièrement préférée d'environ 1,395 g/cm³; et/ou
• le film en PET présentant une épaisseur de l'ordre de 1 à 100 µm, notamment de 2,5 à 75 µm, de préférence de 5 à 50 µm, de manière particulièrement préférée de 6 à 25 µm, de manière tout particulièrement préférée de 7 à 22 µm.

11. Film barrière selon la revendication 9 ou 10, **caractérisé en ce que** le film substrat est conçu sous la forme d'un film monocouche en PET ou encore que le film substrat est conçu sous la forme d'un film multicouches en PET, notamment le film multicouches en PET comprenant au moins trois couches de PET, de préférence de trois à sept couches de PET qui sont reliées entre elles, notamment laminées ou co-extrudées et/ou notamment les différentes couches en PET étant au moins en partie formées de différents types de PET et/ou de différentes compositions de PET et/ou de différentes qualités de PET.

12. Film barrière selon l'une quelconque des revendications 9 à 11, **caractérisé en ce que** le film barrière présente une perméabilité à la vapeur d'eau, déterminée selon la norme DIN 53122/II à 23°C et à 85 % d'humidité relative de l'air de moins de 10 g/m².24 h, notamment de moins de 5 g/m².24 h, de préférence de moins de 4 g/m².24 h, de façon préférée de moins de 3 g/m².24 h, de manière particulièrement préférée de moins de 2 g/m².24 h et/ou
**en ce que** le film barrière présente une perméabilité à l'oxygène, déterminée selon la norme DIN 53380/II à 23°C et à 50 % d'humidité relative de l'air de moins de 10 cm³/m².24 h, notamment de moins de 5 cm³/m².24 h, de préférence de moins de 4 cm³/m².24 h, de manière préférée de moins de 3 cm³ /m².24 h.

13. Film barrière selon l'une quelconque des revendications 1 à 8, **caractérisé en ce que** le film substrat est un film polyoléfine, notamment un film de polypropylène, de préférence un film de polypropylène orienté (film OPP), de manière particulièrement préférée un film de polypropylène à orientation biaxiale (film BOPP).

14. Film barrière selon la revendication 13, **caractérisé en ce que** le film substrat est un film polyoléfine, notamment un film de polypropylène, de préférence un film de polypropylène orienté (film OPP), de manière particulièrement préférée un film de polypropylène à orientation biaxiale (film BOPP),
• le film polyoléfine présentant une résistance à la traction au moins en direction transversale ou longitudinale, de préférence en direction transversale et longitudinale, déterminée selon la norme DIN 53455 à 23° C et à 50 % d'humidité relative de l'air d'au moins 100 N/mm², notamment d'au moins 150 N/mm², de préférence d'au moins 200 N/mm², de manière tout particulièrement préférée d'au moins 300 N/mm²; et/ou
• le film polyoléfine présentant une élongation à la rupture au moins en direction transversale ou longitudinale, de préférence en direction transversale et longitudinale, déterminée selon la norme DIN 53455 à 23° C et à 50 % d'humidité relative de l'air d'au moins 60 %, notamment d'au moins 100 %, de préférence d'au moins 125 %, de manière tout particulièrement préférée d'au moins 150 %; et/ou
• le film polyoléfine présentent une densité déterminée selon ASTM D1505-68, méthode C, à 23° C de 0,85 à 0,95 g/cm³, notamment d'environ 0,9 g/cm³, de manière tout particulièrement préférée d'environ 0,91 g/cm³; et/ou
• le film polyoléfine présentant une épaisseur de l'ordre de 1 à 100 µm, notamment de 2,5 à 75 µm, de préférence de 5 à 50 µm, de manière particulièrement préférée de 10 à 30 µm, de manière tout particulièrement préférée de 12 à 25 µm.

15. Film barrière selon la revendication 13 ou 14, **caractérisé en ce que** le film substrat est conçu sous la forme d'un film polyoléfine monocouche ou encore **en ce que** le film substrat est conçu sous la forme d'un film polyoléfine multicouches, notamment le film polyoléfine multicouches comprenant au moins trois couches de polyoléfine, de préférence de trois à sept couches de polyoléfine qui sont reliées entre elles, notamment laminées ou co-extrudées et/ou notamment les différentes couches de polyoléfine étant au moins en partie formées de différents types de polyoléfines et/ou de différentes compositions de polyoléfines et/ou de différentes qualités de polyoléfines.

16. Film barrière selon l'une quelconque des revendications 13 à 15, **caractérisé en ce que** le film barrière présente une perméabilité à la vapeur d'eau, déterminée selon la norme DIN 53122/II à 23°C et à 85 % d'humidité relative de l'air de moins de 10 g/m².24 h, notamment de moins de 5 g/m².24 h, de préférence de moins de 3 g/m².24 h, de façon préférée de moins de 2 g/m².24 h, de manière particulièrement préférée de moins de 1 g/m².24 h et/ou
**en ce que** le film barrière présente une perméabilité à l'oxygène, déterminée selon la norme DIN 53380/II à 23°C et à 50 % d'humidité relative de l'air de moins de 100 cm³/m².24 h, notamment de moins de 90 cm³/m².24 h, de préférence de moins de 80 cm³/m².24 h, de manière préférée de moins de 70 cm³ /m².24 h, de manière particulièrement préférée de moins de 60 cm³ /m².24 h, de manière tout particulièrement préférée de moins de 70 cm³ /m².24 h.

17. Film barrière selon l'une quelconque des revendications précédentes, **caractérisé en ce que** le film barrière résiste à la stérilisation, notamment à des températures de l'ordre de 100 à 130 °C sur une durée d'environ une demi-heure à de 80 à 90 % d'humidité de l'air et/ou **en ce que** deux films barrières sont disposée par couche l'un sur l'autre, notamment laminés l'un sur l'autre chaque fois par l'intermédiaire de leur couche barrière sur base d'oxyde d'aluminium.

18. Procédé de fabrication d'un film barrière transparent, tel que défini dans l'une quelconque des revendications précédentes, **caractérisé par** un procédé en plusieurs phases de revêtement sous vide par plasma qui comprend les étapes de procédé suivantes dans la séquence ci-dessous citée:
(a) Prétraitement du film substrat par prétraitement au plasma; ensuite
(b) Application d'une première couche mince, notamment d'une épaisseur de moins de 1 à 2 nm, incomplètement close sur base d'oxyde d'aluminium (AlOx) sur au moins une face du film substrat en tant que couche de départ ou couche basale pour la deuxième couche close sur base d'oxyde d'aluminium (AlOx) devant être appliquée lors de l'étape suivante du procédé, notamment par pulvérisation cathodique magnétron, de préférence sous entrée d'oxygène; ensuite
(c) Application d'une deuxième couche close sur base d'oxyde d'aluminium (AlOx) sur la première couche appliquée lors de l'étape de procédé précédente, notamment par vaporisation sous vide activée au plasma, de sorte à obtenir un film barrière transparent tel que défini dans les revendications précédentes qui comporte un film substrat qui sur au moins l'une de ses deux faces est muni d'une couche barrière sur base d'oxyde d'aluminium (AlOx).

19. Utilisation d'un film barrière transparent, tel que défini dans l'une quelconque des revendications précédentes dans le secteur de l'industrie d'emballage, notamment à des fins d'emballage de produits alimentaires.
